# EUROPEAN PATENT APPLICATION

(11) **EP 4 597 543 A1**
(43) Date of publication of application: **06.08.2025**
(21) Application number: 23869929.2
(22) Date of filing: 18.07.2023
(51) Int. Cl.: H01L 21/02

(54) **SILICON CARBIDE EPITAXIAL WAFER AND PREPARATION METHOD THEREFOR**

(30) Priority: 30.09.2022 CN 202211215338
(71) Applicant: BYD Company Limited, Shenzhen, Guangdong 518118 (CN); BYD Auto Industry Company Limited, Guangdong 518118 (CN)
(72) Inventor: GUO, Yuze, Shenzhen, Guangdong 518118 (CN); OU, Canlin, Shenzhen, Guangdong 518118 (CN); ZHOU, Wei, Shenzhen, Guangdong 518118 (CN)
(74) Representative: Mathys & Squire
(86) International application number: PCT/CN2023/107985
(87) International publication number: WO 2024/066682

(57) **Abstract**

The present application relates to the technical field of silicon carbide epitaxial wafers, and discloses a silicon carbide epitaxial wafer and a preparation method therefor. The preparation method comprises the following steps: S1. providing a silicon carbide substrate, and under conditions required for epitaxial growth, sequentially performing buffer layer growth and epitaxial layer growth on the silicon carbide substrate, and obtaining a first product; and S2. sequentially soaking the first product sequentially in a first solution, a second solution and a third solution for cleaning, then cleaning with a fourth solution, and obtaining a silicon carbide epitaxial wafer.

## Description

### CROSS-REFERENCE TO RELATED APPLICATIONS

The present disclosure claims priority to Chinese Patent Application No. 202211215338.X, filed on September 30, 2022 and entitled "Silicon carbide epitaxial wafer and preparation method therefor", the disclosure of which is incorporated herein by reference in its entirety.

### FIELD

The present disclosure relates to the technical field of silicon carbide epitaxy, and specifically to a silicon carbide epitaxial wafer and a preparation method therefor.

### BACKGROUND

Silicon carbide epitaxy is a very critical part in the silicon carbide semiconductor industry, and the epitaxy quality has a great impact on the performances of semiconductor devices. The minority carrier lifetime is directly related to the device performances in the subsequent manufacturing processes, such as on-resistance, breakdown field strength, and switching speed, etc. The minority carrier lifetime is the abbreviation of non-equilibrium minority carrier lifetime, which is a basic parameter for semiconductor materials, and directly reflects the material quality and device characteristics. Therefore, how to improve and effectively control the carrier lifetime in silicon carbide wafers has become a key factor in the development of silicon carbide substrates and epitaxial wafer products.

### SUMMARY

To overcome the technical problem of how to effectively improve the minority carrier lifetime in the silicon carbide epitaxial material existing in related art, an object of the present disclosure is to provide a silicon carbide epitaxial wafer and a preparation method therefor. In the present disclosure, an epitaxial process is combined with a washing process, and the minority carrier lifetime is increased through the cooperation of the two processes, thereby improving the quality of the epitaxial wafer.

To achieve the above object, a first aspect of the present disclosure provides a method for preparing a silicon carbide epitaxial wafer. The preparation method includes the following steps:
S1: A silicon carbide substrate is provided, and a buffer layer and an epitaxial layer are sequentially grown on the silicon carbide substrate under conditions required for epitaxial growth to obtain a first product.
S2: The first product is soaked and washed sequentially with a first solution, a second solution and a third solution, and then washed with a fourth solution, to obtain a silicon carbide epitaxial wafer. In the first solution, the sulfuric acid is 10 wt% to 98 wt%, and the hydrogen peroxide is 10 wt% to 50 wt%. In the second solution, the aqueous ammonia is 5 wt% to 30 wt%, and the hydrogen peroxide is 10 wt% to 50 wt%. In the third solution, the hydrochloric acid is 3 wt% to 40 wt%, and the hydrogen peroxide is 10 wt% to 50 wt%. In the fourth solution, the hydrofluoric acid is 1 wt% to 15 wt%, and the nitric acid is 5 wt% to 70 wt%.

A second aspect of the present disclosure provides a silicon carbide epitaxial wafer, which is prepared by the preparation method according to the first aspect.

Through the above technical solutions, the present disclosure has the following beneficial effects.

In the present disclosure, the epitaxial process and the washing process are closely combined, and the minority carrier lifetime in the epitaxial wafer can be improved by the cooperation of the two processes. Especially for a medium-voltage epitaxial wafer (having a thickness of 8 µm to 20 µm), the improvement of the minority carrier lifetime is remarkable, and no other external contamination is introduced in the method of the present disclosure.

Advantages of the examples of the present disclosure will be partly set forth in the following description, and partly obvious from the specification, or may be learned by practice of the examples of the present disclosure.

### BRIEF DESCRIPTION OF THE DRAWINGS

The accompanying drawings are intended to provide a further understanding of the present disclosure and constitute a part of the specification, and serve to explain the present disclosure together with the following detailed description, but do not constitute a limitation on the present disclosure. In the accompanying drawings:
FIG. 1 shows mapping of the test result of minority carrier lifetime in a silicon carbide epitaxial sample prepared in Example 1 of the present disclosure;
FIG. 2 shows mapping of the test result of surface defects corresponding to the test sample in FIG. 1;
FIG. 3 shows mapping of the test result of minority carrier lifetime in another silicon carbide epitaxial sample in the same batch of products prepared in Example 1 of the present disclosure; and
FIG. 4 shows mapping of the test result of surface defects corresponding to the test sample in FIG. 3.

### DETAILED DESCRIPTION

The endpoints of the ranges and any values disclosed herein are not limited to the precise ranges or values, and these ranges or values should be construed as including values close to these ranges or values. For numerical ranges, endpoint values of each range may be combined, an endpoint value of each range and an individual point value may be combined, and individual point values may be combined, to obtain one or more new numerical ranges, which are to be construed as being specifically disclosed herein.

A first aspect of the present disclosure provides a method for preparing a silicon carbide epitaxial wafer. The preparation method includes the following steps:
S1: A silicon carbide substrate is provided, and a buffer layer and an epitaxial layer are sequentially grown on the silicon carbide substrate under conditions required for epitaxial growth to obtain a first product.
S2: The first product is soaked and washed sequentially with a first solution, a second solution and a third solution, and then washed with a fourth solution, to obtain a silicon carbide epitaxial wafer. In the first solution, the sulfuric acid is 10 wt% to 98 wt%, and the hydrogen peroxide is 10 wt% to 50 wt%. In the second solution, the aqueous ammonia is 5 wt% to 30 wt%, and the hydrogen peroxide is 10 wt% to 50 wt%. In the third solution, the hydrochloric acid is 3 wt% to 40 wt%, and the hydrogen peroxide is 10 wt% to 50 wt%. In the fourth solution, the hydrofluoric acid is 1 wt% to 15 wt%, and the nitric acid is 5 wt% to 70 wt%.

In the present disclosure, there is no particular limitation on the silicon carbide substrate, and a silicon carbide substrate commonly used in the art may be used. For example, the silicon carbide substrate may have a thickness of 300 µm to 400 µm. For example, the silicon carbide substrate has a thickness of 300 µm, 320 µm, 350 µm, 370 µm, or 400 µm, etc.

In Step S2, metal ions on the surface of the epitaxial wafer are removed by washing with the fourth solution.

Step S2 further includes the following: After washing with the fourth solution, hydrofluoric acid on the surface of the epitaxial wafer is removed with dilute hydrochloric acid, and then the epitaxial wafer is spray rinsed with pure water, and dried by blowing under a nitrogen atmosphere, to obtain the silicon carbide epitaxial wafer.

During the growth processes of the buffer layer and the epitaxial layer, the desired flow rates of the carbon source, the silicon source and the doping source and the required growth conditions are selected according to methods conventional in the art.

It should be noted that the flow rate unit slm in the present disclosure can be understood as standard liter/minute. The flow rate unit sccm can be understood as standard cubic centimeter per minute. The pressure unit 1 Torr equals to 1 mmHg.

In some examples, the conditions required for epitaxial growth includes the following. The flow rate of hydrogen is from 10 slm to 200 slm, the pressure of hydrogen is from 0.1 Torr to 800 Torr, and the temperature is from 1000°C to 2000°C. For example, the flow rate of hydrogen is 10 slm, 50 slm, 100 slm, 150 slm, or 200 slm, etc. The pressure of hydrogen is 0.1 Torr, 1 Torr, 5 Torr, 10 Torr, 50 Torr, 100 Torr, 150 Torr, 200 Torr, 250 Torr, 300 Torr, 350 Torr, 400 Torr, 450 Torr, 500 Torr, 550 Torr, 600 Torr, 650 Torr, 700 Torr, 750 Torr, or 800 Torr. The temperature is 1000°C, 1100°C, 1200°C, 1300°C, 1400°C, 1500°C, 1600°C, 1700°C, 1800°C, 1900°C, or 2000°C. In some other examples, the conditions required for epitaxial growth includes the following. The flow rate of hydrogen is from 50 slm to 150 slm, the pressure of hydrogen is from 1 Torr to 600 Torr, and the temperature is from 1200°C to 1800°C. In some other examples, the conditions required for epitaxial growth includes the following. The flow rate of hydrogen is from 80 slm to 120 slm, the pressure of hydrogen is from 200 Torr to 300 Torr, and the temperature is from 1400°C to 1600°C.

According to the present disclosure, the conditions required for epitaxial growth specifically include the following. An epitaxial furnace reaction chamber is vacuumized until the internal pressure is <0.1 Torr. Hydrogen is introduced as an etching atmosphere, the flow rate of hydrogen is controlled to 10 slm to 200 slm, and the pressure and temperature are set to the conditions required for epitaxial growth, where the pressure is set to 0.1 Torr to 800 Torr and the temperature is set to 1000°C to 2000°C.

In some examples, the step for growing the buffer layer include the following. Hydrogen is used as a carrier gas. The flow rates of a first carbon source, a first silicon source and a doping source are adjusted to the flow rates required for the growth of the buffer layer, the temperature is controlled to 1000°C to 2000°C and the pressure is controlled to 0.1 Torr to 800 Torr, to grow the buffer layer. For example, the temperature is 1000°C, 1100°C, 1200°C, 1300°C, 1400°C, 1500°C, 1600°C, 1700°C, 1800°C, 1900°C, or 2000°C. The pressure is 0.1 Torr, 1 Torr, 5 Torr, 10 Torr, 50 Torr, 100 Torr, 150 Torr, 200 Torr, 250 Torr, 300 Torr, 350 Torr, 400 Torr, 450 Torr, 500 Torr, 550 Torr, 600 Torr, 650 Torr, 700 Torr, 750 Torr, or 800 Torr.

In some examples, in the step for growing the buffer layer, the flow rate of hydrogen is from 10 slm to 200 slm, and the ratio of carbon to silicon carried in hydrogen is from 0.1 to 10: 1. For example, the flow rate of hydrogen is 10 slm, 50 slm, 100 slm, 150 slm, or 200 slm. The ratio of carbon to silicon carried in hydrogen is 0.1:1, 0.5:1, 1:1, 1.5:1, 2:1, 2.5:1, 3:1, 3.5:1, 4:1, 4.5:1, 5:1, 5.5:1, 6:1, 6.5:1, 7:1, 7.5:1, 8:1, 8.5:1, 9:1, 9.5:1, or 10:1, etc.

In some other examples, in the step for growing the buffer layer, the flow rate of hydrogen is from 50 slm to 150 slm, and the ratio of carbon to silicon carried in hydrogen is from 1 to 8:1. In some other examples, in the step for growing the buffer layer, the flow rate of hydrogen is from 80 slm to 120 slm, and the ratio of carbon to silicon carried in hydrogen is from 3 to 6:1.

In the present disclosure, the ratio of carbon to silicon refers to the atomic ratio of carbon to silicon carried in the introduced hydrogen.

According to the present disclosure, during the growth of the buffer layer, the flow rate of hydrogen is maintained in the range of 10 slm to 200 slm, and the ratio of carbon to silicon carried in hydrogen is controlled in the range of 0.1 to 10:1.

According to the present disclosure, during the growth processes of the buffer layer and the epitaxial layer, hydrogen is constantly introduced as a carrier gas at the original flow rate without stopping.

According to the present disclosure, the doping source servers to introduce excess valences of electrons or holes, that is, charge carriers, into the product to improve the conductivity of the product.

In some examples, the first carbon source includes at least one of ethylene and propane.

In some examples, the flow rate of the first carbon source is from 10 sccm to 500 sccm, for example, 12 sccm, 15 sccm, 20 sccm, 25 sccm, 30 sccm, 40 sccm, 50 sccm, 60 sccm, 75 sccm, 85 sccm, 95 sccm, 100 sccm, 150 sccm, 180 sccm, 200 sccm, 230 sccm, 275 sccm, 300 sccm, 355 sccm, 395 sccm, 400 sccm, 435 sccm, 455 sccm, 485 sccm, and any value in a range formed by any two of the above numerical values. In some other examples, the flow rate of the first carbon source is between 200 sccm and 400 sccm.

In some examples, the first silicon source includes at least one of silane and trichlorosilane.

In some examples, the flow rate of the first silicon source is from 10 sccm to 500 sccm, for example 12 sccm, 15 sccm, 20 sccm, 25 sccm, 30 sccm, 40 sccm, 50 sccm, 60 sccm, 75 sccm, 85 sccm, 95 sccm, 100 sccm, 150 sccm, 180 sccm, 200 sccm, 230 sccm, 275 sccm, 300 sccm, 355 sccm, 395 sccm, 400 sccm, 435 sccm, 455 sccm, 485 sccm, and any value in a range formed by any two of the above numerical values. In some other examples, the flow rate of the first silicon source is between 200 sccm and 400 sccm.

In some examples, the doping source includes at least one of nitrogen and trimethyl aluminum.

In some examples, the flow rate of the doping source is from 1 sccm to 500 sccm, for example 12 sccm, 15 sccm, 20 sccm, 25 sccm, 30 sccm, 40 sccm, 50 sccm, 60 sccm, 75 sccm, 85 sccm, 95 sccm, 100 sccm, 150 sccm, 180 sccm, 200 sccm, 230 sccm, 275 sccm, 300 sccm, 355 sccm, 395 sccm, 400 sccm, 435 sccm, 455 sccm, 485 sccm, and any value in a range formed by any two of the above numerical values. In some other examples, the flow rate of the doping source is between 200 sccm and 400 sccm.

In some examples, the step for growing the epitaxial layer include the following. The flow rates of a second carbon source and a second silicon source are adjusted to the flow rates required for growing the epitaxial layer, to grow the epitaxial layer. The epitaxial layer is grown to a first thickness at a first growth rate and then grown to a second thickness at a second growth rate during the growth process of the epitaxial layer, wherein the first rate is greater than the second rate.

According to the present disclosure, Step S1 is an epitaxial process, and the epitaxial layer is grown in a manner including initial rapid growth followed by slow growth. When the epitaxial layer grows to about 75% to 90% of the thickness of the epitaxial layer, the growth rate is reduced to perform slow growth. Point defects such as color centers and deep energy level vacancies in silicon carbide are modulated through slow growth to reduce the scattering effect of neutral impurities. Therefore, the conversion between stacking fault (SF) and basal plane dislocations (BPD) is slowed down, and the number of SF, BPD and black (small black dot defects that cannot be specifically identified) on the surface of the epitaxial wafer will be significantly reduced, thus reducing the recombination of minority carriers on the surface.

During the growth process of the epitaxial layer, the second carbon source includes at least one of ethylene and propane in some examples.

In some examples, the flow rate of the second carbon source is from 50 sccm to 500 sccm, for example, 80 sccm, 100 sccm, 150 sccm, 175 sccm, 200 sccm, 300 sccm, 350 sccm, 400 sccm, 450 sccm, 485 sccm, 495 sccm, and any value in a range formed by any two of the above numerical values. In some other examples, the flow rate of the second carbon source is from 100 sccm to 450 sccm.

In some examples, the flow rate of the second silicon source is from 10 sccm to 1000 sccm, for example, 20 sccm, 50 sccm, 100 sccm, 200 sccm, 300 sccm, 400 sccm, 500 sccm, 600 sccm, 750 sccm, 850 sccm, 900 sccm, 950 sccm, and any value in a range formed by any two of the above numerical values. In some other examples, the flow rate of the second silicon source is from 10 sccm to 900 sccm.

In some examples, the second silicon source includes at least one of silane and trichlorosilane.

In some examples, the first growth rate is from 10 µm/h to 100 µm/h, for example, 12 µm/h, 15 µm/h, 20 µm/h, 25 µm/h, 30 µm/h, 40 µm/h, 50 µm/h, 60 µm/h, 75 µm/h, 85 µm/h, 95 µm/h, and any value in a range formed by any two of the above numerical values. In some other examples, the first growth rate is from 35 µm/h to 85 µm/h.

In some examples, the second growth rate is from 1 µm/h to 10 µm/h, for example, 2 µm/h, 3 µm/h, 5 µm/h, 6 µm/h, 7 µm/h, 8 µm/h, 9 µm/h, 9.5 µm/h, and any value in a range formed by any two of the above numerical values. In some other examples, the second growth rate is from 5 µm/h to 8 µm/h.

In some examples, the first thickness is 75% to 90% of the thickness of the epitaxial layer, such as 78%, 80%, 82%, 84%, 85%, 88%, and any value in a range formed by any two of the above numerical values. In some other examples, the first thickness is 80% to 85% of the thickness of the epitaxial layer.

In some examples, the second thickness is 10 to 25% of the thickness of the epitaxial layer, such as 12%, 15%, 18%, 20%, 22%, 24%, and any value in a range formed by any two of the above numerical values.

In some preferred examples, the thickness of the epitaxial layer is from 8 µm to 20 µm, such as 10 µm, 13 µm, 15 µm, 18 µm, and any value in a range formed by any two of the above values. In some other preferred examples, the thickness of the epitaxial layer is from 10 µm to 18 µm.

In the present disclosure, when the thickness of the epitaxial layer is from 8 µm to 20 µm, the first thickness is from 6 µm to 18 µm, for example, the first thickness is from 7 µm to 14 µm, and further the first thickness is from 8 µm to 10 µm.

As the thickness of the epitaxial layer decreases, the surface recombination and bulk recombination rates will slow down, so the minority carrier lifetime will accordingly be significantly improved. With a thickness specification of 8 µm to 20 µm, the increase of minority carrier lifetime will be severely limited, and it is difficult to achieve a significant increase. In the present disclosure, the epitaxial process and the washing process are closely combined, and the minority carrier lifetime in the epitaxial wafer can be improved by the cooperation of the two processes. Especially for a medium-voltage epitaxial wafer (having a thickness of 8 µm to 20 µm), the improvement of the minority carrier lifetime is remarkable, and no other external contamination is introduced in the method of the present disclosure.

Specifically, in the growth process of the epitaxial layer, rapid growth (at a growth rate of 10 µm/h to 100 µm/h, such as 10 µm/h, 15 µm/h, 20 µm/h, 25 µm/h, 30 µm/h, 35 µm/h, 40 µm/h, 45 µm/h, 50 µm/h, 55 µm/h, 60 µm/h, 65 µm/h, 70 µm/h, 75 µm/h, 80 µm/h, 85 µm/h, 90 µm/h, 95 µm/h, 100 µm/h, and any value in a range formed by any two numerical values) is carried out initially. When about 8 µm to 10 µm is grown, the growth rate is reduced to perform slow growth (at a growth rate of 1 µm/h to 10 µm/h, for example, 1 µm/h, 2 µm/h, 5 µm/h, 7 µm/h, 10 µm/h, and any value in a range formed by any two of the above numerical values), and about 1 µm to 2 µm is grown to obtain a 4° off-axis silicon carbide epitaxial wafer substrate.

Due to the different usage of graphite accessories in the furnace, the growth rate is calculated by dividing the measured epitaxial thickness value by the growth time. During the experiment, the flow rates of the carbon source and the silicon source and their flow rate ratio are roughly set initially, and then a sample wafer is grown to confirm the growth rate, before the formal growth is carried out. The growth rate of the sample water is used as the growth rate in the formal experiment. When a current growth rate is 10 µm/h, the approximate flow rate of the second silicon source is from 150 ccm to 250 ccm, such as 150 ccm, 170 ccm, 200 ccm, 220 ccm, 250 ccm, and any value in a range formed by any two of the above numerical values; and the flow rate of the second carbon source is from 60 ccm to 120 ccm, such as 60 ccm, 80 ccm, 100 ccm, 120 ccm, and any value in a range formed by any two of the above numerical values.

It is to be understood that the first growth rate is controlled by adjusting the flow rate of the second silicon source to the range of 100 ccm to 1000 ccm and the flow rate of the second carbon source to the range of 80 ccm to 500 ccm. The flow rate of the second silicon source is between 10 ccm and 80 ccm, and the flow rate of the second carbon source is between 50 ccm and 100 ccm to control the second growth rate.

In some examples, the preparation method further includes the following step: Before washing the first product, preforming a step of annealing on the first product.

In some examples, the annealing step includes the following steps. The introduction of the reaction gases is stopped, hydrogen or a mixed gas of hydrogen and an inert gas is introduced at the growth temperature of the epitaxial layer, the first product is subjected to high-temperature annealing treatment under a hydrogen-rich atmosphere, incubated for 1 h to 2 h, and then cooled to room temperature along with the furnace.

In this step, the flow rate of hydrogen is from 1 slm to 50 slm, for example, 1 slm, 5 slm, 10 slm, 15 slm, 20 slm, 25 slm, 30 slm, 35 slm, 40 slm, 45 slm, and 50 slm etc. The inert gas is Ar or He, and the flow rate of the inert gas is from 1 slm to 10 slm, for example, 1 slm, 5 slm, and 10 slm, etc.

In this example, after the epitaxial growth of silicon carbide is completed, the silicon carbide epitaxy is directly incubated without changing the equipment, thereby saving the time and production cost, reducing the complexity of the process, and facilitating the industrial promotion.

In some other examples of the present disclosure, after the epitaxial growth of silicon carbide is completed, the first product may be transferred from the growth furnace to other high-temperature equipment for annealing treatment. The atmosphere and temperature used in the annealing treatment are the same as those in the above examples, and will not be described herein.

Step S2 is a washing process. In the present disclosure, by adjusting the compositions of the solutions and the washing sequence, metal ions on the surface of the epitaxial layer can be effectively removed, to reduce the trapping effect of metal contamination on minority carriers on the surface of the epitaxial layer, inhibit the recombination of minority carriers on the surface of the silicon carbide wafer, and further improve the minority carrier lifetime in the sample.

In some examples, the first solution is prepared by mixing 98 wt% concentrated sulfuric acid and 30 wt% hydrogen peroxide at a volume ratio of 1 to 3: 1. For example, 98 wt% concentrated sulfuric acid and 30 wt% hydrogen peroxide are mixed at a volume ratio of 1:1, 2:1, or 3:1.

In some examples, the second solution is prepared by mixing 27 wt% aqueous ammonia, 30 wt% hydrogen peroxide, and pure water at a volume ratio of 1:1 to 3:3 to 10. For example, 27 wt% aqueous ammonia, 30 wt% hydrogen peroxide, and pure water are mixed at a volume ratio and of 1:1:3 to 10, 1:2:3 to 10, 1:3:3 to 10, 1:1 to 3:3, 1:1 to 3:5, 1:1 to 3:7, 1:1 to 3:9, or 1:1 to 3:10.

In some examples, the third solution is prepared by mixing 37 wt% hydrochloric acid, 30 wt% hydrogen peroxide, and pure water at a volume ratio of 1:1 to 5:5 to 15. For example, 37 wt% hydrochloric acid, 30 wt% hydrogen peroxide, and pure water are mixed at a volume ratio of 1:1:5 to 15, 1:2:5 to 15, 1:3:5 to 15, 1:4:5 to 15, 1:5:5 to 15, 1:1 to 5:5, 1:1 to 5:7, 1:1 to 5:9, 1:1 to 5:10, 1:1 to 5:12, 1:1 to 5:13, or 1:1 to 5:15.

In some examples, the fourth solution is prepared by mixing 38 wt% hydrofluoric acid, 55 wt% nitric acid and pure water at a volume ratio of 1:1 to 3:3 to 10. For example, 38 wt% hydrofluoric acid, 55 wt% nitric acid and pure water are mixed at a volume ratio of 1:1:3 to 10, 1:2:3 to 10, 1:3:3 to 10, 1:1 to 3:3, 1:1 to 3:5, 1:1 to 3:7, 1:1 to 3:9, or 1:1 to 3:10.

In some examples, Step S2 further includes the following steps. After washing with the fourth solution, hydrofluoric acid on the surface of the epitaxial wafer is removed with dilute hydrochloric acid, and then the epitaxial wafer is spray rinsed with pure water, and dried by blowing under a nitrogen atmosphere, to obtain the silicon carbide epitaxial wafer.

In some examples, the dilute hydrochloric acid concentration is from 3 wt% to 15 wt%, for example, 3 wt%, 5 wt%, 7 wt%, 10 wt%, 12 wt%, 15 wt%, and any value in a range formed by any two of the above numerical values.

A second aspect of the present disclosure provides a silicon carbide epitaxial wafer produced by the aforementioned preparation method.

In some preferred examples, the thickness of the epitaxial layer on the silicon carbide epitaxial wafer is from 8 µm to 20 µm, such as 10 µm, 13 µm, 15 µm, 18 µm, and any value in a range formed by any two of the above values. In some other examples, the thickness of the epitaxial layer on the silicon carbide epitaxial wafer is from 10 µm to 18 µm.

In some examples, the silicon carbide epitaxial wafer has a minority carrier lifetime of 100 ns to 320 ns, for example, 100 ns, 120 ns, 150 ns, 180 ns, 200 ns, 220 ns, 250 ns, 280 ns, 300 ns, and 320 ns, etc. In some other examples, the silicon carbide epitaxial wafer has a minority carrier lifetime of 160 ns to 300 ns.

In the present disclosure, the minority carrier lifetime can be detected by a minority carrier lifetime detection method (GB/T26068-2018).

In some examples, on the surface of the silicon carbide epitaxial wafer, the total defect number is 700 or less, the particle number is 10 or less, the pit number is 200 or less, the SF and BPD number are both 100 or less, the black number is 200 or less, and the content of Fe contamination is below the order of magnitude of E9, that is, the content of Fe ions is not higher than 10⁹ atoms/cm⁻².

In some other examples, on the surface of the silicon carbide epitaxial wafer, the total defect number is 600 or less, the particle number is 8 or less, the pit number is 150 or less, the SF and BPD number are both 90 or less, the black number is 180 or less, and the content of Fe contamination is below the order of magnitude of E9, that is, the content of Fe ion is not higher than 10⁹ atoms/cm⁻².

In the present disclosure, the particle represents particle matter, pit represents depressions, SF represents stacking faults, BPD represents basal plane dislocations, and black represents small black dot defects that cannot be specifically identified, on the surface of the silicon carbide epitaxial wafer. The above parameters can be detected by the detection method for silicon carbide epitaxial defects (GB/T 17167-1997).

The content of Fe contamination indicates the iron ion content, which can be detected by the detection method for metal ion contamination (GB/T 39145-2020).

In the method according to the present disclosure, the epitaxial process and the washing process are combined, and the minority carrier lifetime is improved significantly by the cooperation of the two processes, particularly for a medium-voltage epitaxial wafer (8 µm to 20 µm).

In the epitaxial growth stage, the epitaxial wafer has more point defects such as carbon vacancies and hydrogen impurities during the growth process, which leads to the formation of SF, and slowly expands to the surface to form BPD with the growth, causing more defects on the surface of the grown epitaxial wafer, for example, stacking faults (SF), basal plane dislocations (BPD), black (small black dot defects that cannot be specifically identified) and pit (depression), etc. The traps formed by these defects on the surface will trap the excited minority carriers, exacerbating the surface recombination effect. Moreover, during the processing and washing process of the substrate, a large number of metal ions will also be introduced by the processing equipment and chemical liquid, and the surface charge of the metal ions will also neutralize the minority carriers, resulting in a low minority carrier lifetime in the newly grown epitaxial wafer.

According to a particularly preferred example of the present disclosure, for example, a method for preparing a silicon carbide epitaxial wafer having an epitaxial layer thickness of 8 µm to 20 µm includes the following steps:
S1: A growth process includes the following steps.
S11: A silicon carbide substrate (having a thickness of 300 µm to 400 µm) is placed at a mounting position in an epitaxial furnace (class 100 environment, that is, an environment with a cleanliness is level 100), and transferred to an epitaxial furnace reaction chamber by a mechanical arm. The reaction chamber is vacuumized so that the pressure inside the reaction chamber is < 0.1 Torr.
S12: Hydrogen is introduced as an etching atmosphere. The hydrogen flow rate is 10 slm to 200 slm, and the pressure and temperature are set to the conditions required for epitaxial growth. The pressure is set to 0.1 Torr to 800 Torr, and the temperature is set to 1000°C to 2000°C. The flow rates of a carbon source, a silicon source and a doping source are adjusted to the flow rates required for growing the buffer layer (carbon source: 10 sccm to 500 sccm, silicon source: 10 sccm to 500 sccm, doping source: 1 sccm to 500 sccm). At this time, hydrogen is constantly introduced as a carrier gas at the original flow rate without stopping, and the carbon to silicon ratio (that is, the atomic ratio of carbon to silicon of the introduced gases) is set to 0.1 to 10: 1. All gases are set to be exhausted until the temperature and pressure in the reaction chamber of the epitaxial furnace reach the required value.
S13: When the temperature (1000°C to 2000°C) and pressure (0.1 Torr to 800 Torr) in the epitaxial furnace reaction chamber reach the requirements and tend to be stable, the gases and doping source are introduced into the reaction chamber to grow a buffer layer having a thickness of 1 µm to 5 µm. After the buffer layer is grown, the flow rates of the carbon source and the silicon source are adjusted to the flow rates required for growing the epitaxial layer (carbon source: 50 sccm to 500 sccm, and silicon source: 10 sccm to 1000 sccm) to grow an epitaxial layer. Rapid growth is performed initially (at a growth rate of 10 µm/h to 100 µm/h). When the epitaxial layer is grown to 75% to 90% of the thickness, the growth rate is reduced. Slow growth (at a growth rate of 1 µm/h to 10 µm/h) is performed, and the epitaxial layer is grown to a thickness of is 8 µm to 20 µm, to obtain a 4° off-axis silicon carbide epitaxial wafer.
S14. The introduction of the reaction gas is stopped, the temperature is kept unchanged, hydrogen (flow rate 1 slm to 50 slm) and an inert gas (such as Ar or He, flow rate 1 slm to 10 slm) are introduced into the epitaxial furnace reaction chamber, and the epitaxial wafer is annealed at a high temperature under a hydrogen-rich atmosphere. The temperature is maintained for 1 h to 2 h, then the product is cooled to room temperature with the furnace, and then taken out.
S2: A washing process includes the following steps.
S21. The product obtained in S1 is washed in an SPM (a mixture of sulfuric acid and hydrogen peroxide, 98 wt% concentrated sulfuric acid + 30 wt% hydrogen peroxide mixed at a volume ratio of 3:1) tank where the chemical liquid is SPM; ultrasonically washed in an ultrasonic washing device; and then transferred to and soaked and washed in an SC1 (27 wt% aqueous ammonia + 30 wt% hydrogen peroxide + pure water mixed at a volume ratio of 1: 1: 3) tank; and finally transfer to and soaked and washed in an SC2 (37 wt% hydrochloric acid + 30 wt% hydrogen peroxide + pure water mixed at a volume ratio of 1: 1: 5) tank. This step is routine washing, by which particle contaminants (0.1 µm to 1 µm in diameter) on the surface of the product can be washed away.
S22: 38 wt% hydrofluoric acid + 55 wt% nitric acid + pure water are mixed at a volume ratio of 1: 1: 3, and then used to remove metal ions.
S23: Finally, hydrofluoric acid is removed by spray washing with a chemical liquid that is 15 wt% dilute hydrochloric acid.
S24: The product is spray washed with pure water and blow dried under a nitrogen atmosphere to obtain a silicon carbide epitaxial wafer product with a high minority carrier lifetime.

The present disclosure will be described below with reference to specific examples. It should be noted that these examples are merely descriptive and do not limit the present disclosure in any way.

In the following examples and comparative examples, the minority carrier lifetime detection method (GB/T26068-2018) is microwave photoconductivity decay (µ-PCD) method. Microwave photoconductivity decay is mainly used to monitor carrier recombination in materials. The test system includes a semiconductor laser, a circulator, a microwave generator, a detector, and a flat panel display. The light source selected in the test is generally a YAG laser pump source, the wavelength of the emitted pulse wave is generally 349 nm, and the duration of each pulse is 200 ns. After the test sample is excited by laser, non-equilibrium carriers are generated, which changes the conductivity of the semiconductor material. The infrared light emitted by the detector is reflected by the sample surface and captured by the reflection detector as a detection signal. After passing through the circulator, it is converted into an electrical signal and displayed on a transient oscilloscope in the form of an intuitive voltage curve, to reflect the changing pattern of minority carrier lifetime.

The detection method for silicon carbide epitaxial defects (GB/T 17167-1997) is an optical surface analysis technology, which can simultaneously measure the scattering intensity, shape change, surface reflectivity and phase shift. By combining the basic principles of scatterometry, ellipsometry, reflectometry and optical shape analysis, it can detect residual foreign matter on the surface of silicon wafers, surface and subsurface defects, shape changes, and film thickness uniformity in a non-destructive manner. In the method, laser is used as a light source, and a divergent beam with highly uniform wavefront is formed by the coherence of the laser and multi-channel spatial filtering, with which the sample surface is irradiated. Due to different kinds of defects on the sample surface, the beam of the reflected wavefront is distorted. The distorted wavefront is spatially folded and amenable to coherent imaging, to form images corresponding to various defects. The reflected beam is received by a receiving device (such as CCD, etc.), and a state analysis result of the sample surface can be displayed on a screen after processing by an algorithm.

Detection method of metal ion contamination (GB/T 39145-2020): ICP-MS method. The metal elements on the silicon carbide wafer are dissolved with nitric acid to obtain a scanning liquid containing metal ions. The sample of the silicon carbide scanning liquid is atomized, and small droplets are screened, and entered into inductively coupled plasma at a high temperature of 8,000-10,000 K. The inorganic elements to be measured are ionized into ions with a positive charge after being gasified, atomized and ionized successively. Then, the positive ions are screened by a quadrupole rod ion deflection system and the interfering ions are completely eliminated by a quadrupole rod collision reaction cell system. Finally, the ions are scanned by a quadrupole rod mass analyzer and then entered a detector system for qualitative and quantitative analysis.

### Example 1

The silicon carbide epitaxial wafer is prepared by a method including an epitaxial process and a washing process in combination. The method is as follows.

S1: Epitaxial process: The reaction chamber is vacuumized to have an internal pressure of 0.1 Torr or less. The flow rate of hydrogen is 150 slm, the temperature is 1640°C, the carbon to silicon ratio is 0.5, the flow rate of the silicon source trichlorosilane (TCS) is 50 sccm, and the flow rate of the carbon source ethylene is 15 ccm. A 1 µm buffer layer is grown. After the buffer layer is grown, the flow rate of the carbon source is adjusted to 80 sccm and the flow rate of the silicon source is adjusted to 180 sccm. An epitaxial layer is grown. Rapid growth is carried out initially (at a growth rate of 15 µm/h). When 9 µm is grown, the growth rate is reduced. Slow growth is carried out (at a growth rate of 5 µm/h). About 2 µm is grown. At this time, the epitaxial layer is completely grown. The introduction of the reaction gas is stopped, the temperature is kept unchanged (1640°C), hydrogen (at a flow rate of 2 slm) is introduced into the epitaxial furnace reaction chamber, and the epitaxial wafer is annealed at a high temperature under a hydrogen-rich atmosphere. The temperature is maintained for 1 h, then the product is cooled to room temperature with the furnace, and then taken out.

S2. Washing process: The product obtained in Step S1 is soaked and washed with SPM (98 wt% concentrated sulfuric acid + 30 wt% hydrogen peroxide at a volume ratio of 3: 1) + SC1 (27 wt% aqueous ammonia + 30 wt% hydrogen peroxide + pure water at a volume ratio of 1: 1: 3) + SC2 (37 wt% hydrochloric acid + 30 wt% hydrogen peroxide + pure water at a volume ratio of 1: 1: 5). 38 wt% hydrofluoric acid + 55 wt% nitric acid + pure water are mixed at a volume ratio of 1: 1: 3 and used to remove metal ions. Then hydrofluoric acid is removed with 15 wt% dilute hydrochloric acid. Finally, the product is spray washed with pure water and dried by blowing under a nitrogen atmosphere, to obtain a silicon carbide epitaxial wafer.

After test, the data of the silicon carbide epitaxial wafer is shown in Table 1.

In this example and the following examples and comparative examples, specific methods for data acquisition are as follows: Three silicon carbide epitaxial wafer samples of the same batch are selected and tested respectively. Then the detected data are averaged to obtain the data of the silicon carbide epitaxial wafer. The data is shown in Table 1.

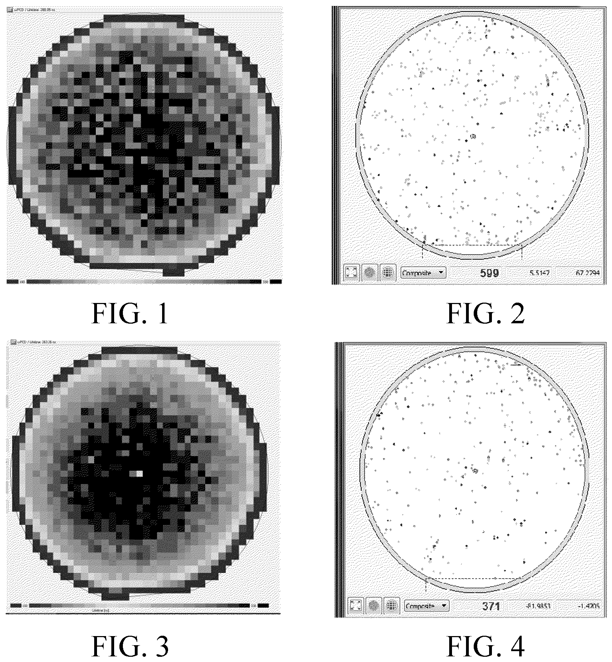

FIGs. 1 to 4 shows the test results of the silicon carbide epitaxial wafer. , FIG. 1 shows mapping of the test result of minority carrier lifetime in a silicon carbide epitaxial sample prepared in Example 1 of the present disclosure. FIG. 2 shows mapping of the test result of surface defects corresponding to the test sample in FIG. 1. FIGs. 3 and 4 respectively show mapping of the test result of minority carrier lifetime in another silicon carbide epitaxial wafer sample in the same batch of products prepared in Example 1 of the present disclosure and mapping of the test result of surface detects. It can be seen from FIGs. 2 and 4 that with the special epitaxial growth and washing process described in the present disclosure, on the surface of the wafer (silicon carbide epitaxial wafer), the total defect number is 600 or less, the particle number is 5 or less, the pit number is 200 or less, the SF and BPD number are 50 or less, and the black number is 120 or less. It can be seen that BPD, SF, pit and black are obviously controlled in this process. The Fe contamination on the surface is tested, and the concentration is at the E8 level (that is, the Fe ion content is not higher than 10⁸ atoms/cm⁻²), indicating that the contamination is mild. It can be seen from FIGs. 1 and 3 that the minority carrier lifetime can be up to 280 ns, which is at an extremely high level for a range of epitaxial thickness required by medium voltage.

### Example 2

The method in Example 1 is used, except that in Step S1, the rapid growth rate is 15 µm/h, the slow growth rate is 1 µm/h, and the remaining conditions are the same. A silicon carbide epitaxial wafer is obtained.

After test, the data of the silicon carbide epitaxial wafer is shown in Table 1.

### Example 3

The method in Example 1 is used, except that in Step S1, the rapid growth rate is 15 µm/h, the slow growth rate is 9 µm/h, and the remaining conditions are the same. A silicon carbide epitaxial wafer is obtained.

After test, the data of the silicon carbide epitaxial wafer is shown in Table 1.

### Example 4

The method in Example 1 is used, except that in Step S1, the rapid growth rate is 15 µm/h, the slow growth rate is 9 µm/h, and the remaining conditions are the same. A silicon carbide epitaxial wafer is obtained.

After test, the data of the silicon carbide epitaxial wafer is shown in Table 1.

### Example 5

The method in Example 1 is used, except that in Step S1, the rapid growth rate is 15 µm/h, the slow growth rate is 9 µm/h, and the remaining conditions are the same. A silicon carbide epitaxial wafer is obtained.

After test, the data of the silicon carbide epitaxial wafer is shown in Table 1.

### Example 6

The method in Example 1 is used, except that in Step S 1, the epitaxial growth is carried out at the same growth rate. After the buffer layer is grown, the whole epitaxial film is grown at a high rate (15 µm/h), and no slow growth process is included. the remaining conditions are the same. A silicon carbide epitaxial wafer is obtained.

After test, the data of the silicon carbide epitaxial wafer is shown in Table 1.

### Example 7

The method in Example 1 is used, except that in Step S1, after the epitaxial layer is grown, it is directly entered into the washing process without high-temperature annealing under a hydrogen atmosphere, and the remaining conditions are the same. A silicon carbide epitaxial wafer is obtained.

After test, the data of the silicon carbide epitaxial wafer is shown in Table 1.

### Comparative Example 1

The method in Example 1 is used, except that the washing in Step S2 is different. No nitric acid + hydrofluoric acid washing process is included; and the remaining conditions are the same. A silicon carbide epitaxial wafer is obtained.

After test, the data of the silicon carbide epitaxial wafer is shown in Table 1.

### Comparative Example 2

The method in Example 1 is used, except that only the epitaxial preparation process is employed, that is, only Step S1 in Example 1 is included, to obtain the silicon carbide epitaxial wafer, and the subsequent washing process S2 is not performed.

After test, the data of the silicon carbide epitaxial wafer is shown in Table 1.

**Table 1**

| No. | Minority carrier lifetime (ns) | Black + PL _Black | Particle | Pit | SF+SSF | BPD | Fe contamination |
|---|---|---|---|---|---|---|---|
| Example 1 | 281.34 | 115 | 4 | 118 | 34 | 34 | 8.73E8 |
| Example 2 | 289.67 | 110 | 7 | 109 | 35 | 33 | 8.89E8 |
| Example 3 | 268.51 | 124 | 6 | 139 | 42 | 41 | 8.71E8 |
| Example 4 | 261.02 | 158 | 8 | 147 | 66 | 73 | 9.01E8 |
| Example 5 | 252.13 | 172 | 6 | 163 | 81 | 87 | 8.89E8 |
| Example 6 | 197.65 | 186 | 9 | 192 | 86 | 83 | 8.96E8 |
| Example 7 | 164.38 | 189 | 6 | 131 | 58 | 39 | 9.11E8 |
| Comparative Example 1 | 98.48 | 200 | 24 | 120 | 31 | 42 | 8.7E10 |
| Comparative Example 2 | 92.41 | 538 | 53 | 214 | 165 | 137 | 10.0E10 |

Remark: PL black refers to the black observed in the PL layer (5 µm to 8 µm inside the wafer); black (small black dot defects that cannot be specifically identified) are the black observed on the surface of the wafer; and SSF refers to Shockley-type stacking faults. The above parameters can be detected by the detection method for silicon carbide epitaxial defects (GB/T 17167-1997).

From the results in Table 1, it can be seen that on the surface of the silicon carbide epitaxial wafer obtained by combining the epitaxial process and the washing process in Examples 1 to 7 of the present disclosure, the total defect number is 700 or less, the particle number is 10 or less, the pit number is 200 or less, the SF and BPD number are both 100 or less, the black number is 200 or less, and the content of Fe contamination is below the order of magnitude of E9. Through comparison, it can be seen that the minority carrier lifetime in the silicon carbide epitaxial wafers obtained in Examples 1 to 7 of the present disclosure is significantly higher than that in Comparative Examples 1 and 2, and BPD, SF, pit and black are also obviously controlled, which are at an extremely high level for the range of epitaxial thickness required by medium voltage.

The washing process adopted in Comparative Example 1 has no nitric acid + hydrofluoric acid washing process. The minority carrier lifetime in the epitaxial wafer is less than about 100 ns. The particle and black numbers on the surface of the epitaxial wafer are significantly increased, and Fe contamination is significantly increased by about 1 to 2 orders of magnitude.

In Comparative Example 2, only the epitaxial process is used. When no washing is performed, the minority carrier lifetime in the epitaxial wafer is less than about 100 ns, the pit, SF, BPD and black numbers increase significantly, and the Fe contamination is also serious.

It can be seen from the above that by combining the epitaxial process with the special washing process, the present disclosure can significantly improve the minority carrier lifetime in the silicon carbide epitaxial wafer, and significantly reduce the total of surface defect number, the particle, pit, SF (stacking fault), BPD (basal plane dislocation), and black (small black dot defects that cannot be specifically identified) numbers, and the Fe contamination content. By controlling a mode of rapid growth and slow growth of the epitaxial layer in combination, the minority carrier lifetime and performance of the silicon carbide epitaxial wafer are further improved.

The above examples are only several implementations of the present application, and are described in detail, which, however, are not to be construed as a limitation to the scope of the present disclosure. It is to be understood that for a person of ordinary skill in the art, several variations and improvements can be made without departing from the idea of the present disclosure, which are all contemplated in the protection scope of the present disclosure. Therefore, the scope of protection of the present disclosure is defined by the appended claims.

## Claims

1. A method for preparing a silicon carbide epitaxial wafer, comprising:
S1: providing a silicon carbide substrate, and sequentially growing a buffer layer and an epitaxial layer on the silicon carbide substrate under conditions required for epitaxial growth, to obtain a first product; and
S2: soaking and washing the first product sequentially with a first solution, a second solution and a third solution, and then washing with a fourth solution, to obtain a silicon carbide epitaxial wafer, wherein in the first solution, the sulfuric acid is 10 wt% to 98 wt%, and the hydrogen peroxide is 10 wt% to 50 wt%; in the second solution, the aqueous ammonia is 5 wt% to 30 wt%, and the hydrogen peroxide is 10 wt% to 50 wt%; in the third solution, the hydrochloric acid is 3 wt% to 40 wt%, and the hydrogen peroxide is 10 wt% to 50 wt%; and in the fourth solution, the hydrofluoric acid is 1 wt% to 15 wt%, and the nitric acid is 5 wt% to 70 wt%.

2. The method according to claim 1, wherein the conditions required for epitaxial growth comprise a flow rate of hydrogen ranging from 10 slm to 200 slm, a pressure of hydrogen ranging from 0.1 Torr to 800 Torr, and a temperature ranging from 1000°C to 2000°C.

3. The method according to claim 1 or 2, wherein the step of growing a buffer layer comprises: using hydrogen as a carrier gas, adjusting the flow rates of a first carbon source, a first silicon source, and a doping source to the flow rates required for the growth of the buffer layer, and controlling the temperature between 1000°C and 2000°C and the pressure between 0.1 Torr and 800 Torr, to grow the buffer layer.

4. The method according to claim 3, wherein the flow rate of hydrogen is from 10 slm to 200 slm, and the ratio of carbon to silicon carried in hydrogen is from 0.1 to 10: 1.

5. The method according to any one of claims 1 to 4, wherein the step of growing an epitaxial layer comprises: adjusting the flow rates of a second carbon source and a second silicon source to the flow rates required for the growth of the epitaxial layer, to grow the epitaxial layer, wherein the epitaxial layer is grown to a first thickness at a first growth rate and then grown to a second thickness at a second growth rate during the growth process of the epitaxial layer, and the first rate is greater than the second rate.

6. The method according to claim 5, wherein the first thickness is 75% to 90% of the thickness of the epitaxial layer.

7. The method according to claim 5 or 6, wherein the second thickness is 10% to 25% of the thickness of the epitaxial layer, and the thickness of the epitaxial layer is 8 µm to 20 µm.

8. The method according to any one of claims 1 to 7, further comprising: before washing the first product, preforming a step of annealing on the first product.

9. The method according to claim 8, wherein the step of annealing comprises: stopping the introduction of the reaction gases, introducing hydrogen or a mixed gas of hydrogen and an inert gas at the growth temperature of the epitaxial layer, subjecting the first product to a high-temperature annealing treatment under a hydrogen-rich atmosphere, incubating for 1 h to 2 h, and then cooling to room temperature along with the furnace.

10. The method according to any one of claims 1 to 9, wherein the first solution is prepared by mixing 98 wt% concentrated sulfuric acid and 30 wt% hydrogen peroxide at a volume ratio of 1 to 3: 1.

11. The method according to any one of claims 1 to 10, wherein the second solution is prepared by mixing 27 wt% aqueous ammonia, 30 wt% hydrogen peroxide, and pure water at a volume ratio of 1: 1 to 3: 3 to 10.

12. The method according to any one of claims 1 to 11, wherein the third solution is prepared by mixing 37 wt% hydrochloric acid, 30 wt% hydrogen peroxide, and pure water at a volume ratio of 1: 1 to 5: 5 to 15.

13. The method according to any one of claims 1 to 12, wherein the fourth solution is prepared by mixing 38 wt% hydrofluoric acid, 55 wt% nitric acid, and pure water at a volume ratio of 1: 1 to 3: 3 to 10.

14. The method according to any one of claims 1 to 13, wherein Step S2 further comprises: after washing with the fourth solution, removing hydrofluoric acid on the surface of the epitaxial wafer with dilute hydrochloric acid, then spray rinsing with pure water, and drying by blowing under a nitrogen atmosphere, to obtain the silicon carbide epitaxial wafer.

15. The method according to claim 14, wherein the concentration of the dilute hydrochloric acid is 3 wt% to 15 wt%.

16. A silicon carbide epitaxial wafer, prepared by the preparation method according to any one of claims 1 to 15.

17. The silicon carbide epitaxial wafer according to claim 16, wherein the thickness of the epitaxial layer on the silicon carbide epitaxial wafer is 8 µm to 20 µm.

18. The silicon carbide epitaxial wafer according to claim 16 or 17, wherein the thickness of the epitaxial layer on the silicon carbide epitaxial wafer is 10 µm to 18 µm.

19. The silicon carbide epitaxial wafer according to any one of claims 16 to 18, wherein the minority carrier lifetime in the silicon carbide epitaxial wafer is 100 ns to 320 ns.

20. The silicon carbide epitaxial wafer according to any one of claims 16 to 19, wherein the minority carrier lifetime in the silicon carbide epitaxial wafer is 160 ns to 300 ns.

21. The silicon carbide epitaxial wafer according to any one of claims 16 to 20, wherein on the surface of the silicon carbide epitaxial wafer, a total defect number is 700 or less, a particle number is 10 or less, a pit number is 200 or less, SF and BPD numbers are both 100 or less, a black number is 200 or less, and content of Fe contamination is below the order of magnitude of E9.

22. The silicon carbide epitaxial wafer according to any one of claims 16 to 21, wherein on the surface of the silicon carbide epitaxial wafer, the total defect number is 600 or less, the particle number is 8 or less, the pit number is 150 or less, the SF and BPD number are both 90 or less, the black number is 180 or less, and the content of Fe contamination is below the order of magnitude of E9.
